# EUROPÄISCHE PATENTANMELDUNG

(11) **EP 1 109 428 A2**
(43) Veröffentlichungstag der Anmeldung: **20.06.2001**
(21) Anmeldenummer: 00122051.6
(22) Anmeldetag: 11.10.2000
(51) Int. Cl.: H05K 1/02

(54) **Thermomechanisch kompensierte Leiterplatte**

(30) Priorität: 30.11.1999 DE 19957554
(71) Anmelder: ROBERT BOSCH GMBH, 70442 Stuttgart (DE)
(72) Erfinder: Khilla, Abdel-Messiah, 71522 Backnang (DE); Katz, Hanspeter, 70374 Stuttgart (DE); Spinnler, Matthias, 71566 Althuette (DE)

(57) **Zusammenfassung**

Eine Leiterplatte für die Montage von wenigstens zwei Gruppen von Schaltungsbausteinen (5,6,7), die sich in ihren thermischen Ausdehnungskoeffizienten unterscheiden, ist an einem oder mehreren Orten mit einer steifen Einlage (2) ausgestattet, deren thermischer Ausdehnungskoeffizient sich von dem des Materials der Leiterplatte (1) unterscheidet, so daß der Ausdehnungskoeffizient der Leiterplatte an diesem Ort/diesen Orten sich vom Ausdehnungskoeffizienten der Leiterplatte (1) an Orten, die die Einlage nicht aufweisen, unterscheidet.

## Beschreibung

### Stand der Technik

Die vorliegende Erfindung betrifft eine Leiterplatte für die Montage von wenigstens zwei Gruppen von Schaltungsbausteinen, die sich in ihren thermischen Ausdehnungskoeffizienten unterscheiden.

Herkömmliche Leiterplatten weisen im allgemeinen einen thermischen Ausdehnungskoeffizienten auf, der sich von dem der darauf montierten Schaltungsbausteine unterscheidet. Dies führt zu Schwierigkeiten bei Anwendungen, bei denen eine Leiterplatte und die darauf montierten Komponenten starken Temperaturwechseln ausgesetzt sind, wie zum Beispiel im Bereich der Raumfahrt. Thermische Spannungen zwischen Schaltungsbausteinen und Substrat können zu einem Aufplatzen der mechanischen Verbindung zwischen beiden und zur Zerstörung von elektrischen Verbindungsleitungen führen. Dies hat dazu geführt, dass zum Beispiel MMIC- beziehungsweise MIC-Module, die ein Gehäuse aus Keramikmaterial oder einem Material mit keramikähnlichem Ausdehnungskoeffizienten aufweisen, nicht direkt auf einer Leiterplatte montiert werden, sondern auf einer von der Leiterplatte getrennten Stahl- oder Vacon-Trägerplatte, die in einem Abstand von einer zugehörigen Leiterplatte durch eine Mehrzahl von Stiften beziehungsweise Schrauben gehaltert ist. Über Durchgangsfiltern werden die Versorgungsspannungen und Signale den auf der Trägerplatte montierten Module zugeführt. Da die Trägerplatte und die Leiterplatte nicht in direktem Kontakt stehen, beeinträchtigen unterschiedliche thermische Ausdehnungskoeffizienten dieser zwei Platten nicht die Stabilität und dauerhafte Funktionsfähigkeit der gesamten Anordnung.

Eine solche Konstruktion ist aber in der Fertigung aufwendig, denn wenn ein elektronisches Gerät unterschiedliche Gruppen von Schaltungsbausteinen enthält, von denen die einen direkt auf der Leiterplatte befestigt werden können, die anderen aber nicht, so ist für die Montage dieser anderen Schaltungsbausteine auf der Trägerplatte ein von der Bestückung der Leiterplatte völlig getrennter Bestückungsprozeß erforderlich, der zum Teil andere Bestückungstechniken erfordert als die Bestückung der Leiterplatte und daher zeit- und kapitalintensiv ist. Des weiteren fällt mit dem notwendigen Zusammenmontieren und elektrischen Kontaktieren der Schaltungsbausteine der Trägerplatte mit denen der Leiterplatte ein zusätzlicher Bearbeitungsschritt an, den zu vermeiden wünschenswert wäre, da er Zeit- und Kostenaufwand mit sich bringt und Ursache von Fehlern sein kann. Auch unter dem gerade in der Raumfahrttechnik äußerst wichtigen Aspekt der Gewichtsreduzierung wäre es wünschenswert, auf die metallische Trägerplatte für die Montage der Mikrowellenmodule verzichten zu können.

### Vorteile der Erfindung

Durch die vorliegende Erfindung wird eine Leiterplatte geschaffen, die es ermöglicht, Schaltungsbausteine mit unterschiedlichen thermischen Ausdehnungskoeffizienten auf einer gemeinsamen Leiterplatte zu montieren, ohne daß die Gefahr einer mechanischen Beschädigung oder Zerstörung der Schaltung im Falle von starken Temperaturwechseln besteht. Das Gewicht der erfindungsgemäßen Leiterplatte kann deutlich geringer gehalten werden als das der herkömmlichen Konstruktion mit Leiterplatte und Trägerplatte.

Durch die Möglichkeit, Schaltungsbausteine mit unterschiedlichen Ausdehnungskoeffizienten auf einer einheitlichen Leiterplatte zu montieren, entfällt die Notwendigkeit von getrennten Bestückungsprozessen und dementsprechend auch die Notwendigkeit, in den verschiedenen Prozessen bestückte Platten zusammenzumontieren.

Alle diese Vorteile werden dadurch erzielt, dass erfindungsgemäß die Leiterplatte an einem oder mehreren Orten mit eine steifen Einlage ausgestattet ist, deren thermischer Ausdehnungskoeffizient sich von dem des Materials der Leiterplatte unterscheidet, so daß der Ausdehnungskoeffizient der Leiterplatte am Ort einer solchen Einlage vom Ausdehnungskoeffizienten der Leiterplatte an Orten ohne eine solche Einlage unterscheidet.

Diese Einlage wird vorzugsweise so gewählt, dass der Ausdehnungskoeffizient der Leiterplatte am Ort einer Einlage im Bereich von 3 bis 9, vorzugsweise von 4 bis 6x10⁻⁶/°C liegt. Dies erlaubt die Montage von Schaltungsbausteinen mit Keramikgehäuse wie etwa MMIC- oder MIC-Modulen direkt auf der Leiterplatte, obwohl das Material der Leiterplatte von Natur aus einen deutlich höheren thermischen Ausdehnungskoeffizienten (zum Beispiel 12 bis 16x10⁻⁶ /°C im Falle einer Leiterplatte aus FR4-Material) haben kann.

Die Orte der Leiterplatte, die eine solche versteifende Einlage aufweisen, sind natürlich vorzugsweise mit Schaltungsbausteinen derjenigen Gruppe bestückt, deren thermischer Ausdehnungskoeffizient dem der Leiterplatte mit Einlage am nächsten kommt.

Wie groß der tatsächliche Ausdehnungskoeffizient im Bereich einer steifen Einlage ist, hängt selbstverständlich vom Material der Einlage, ihrer Dicke im Verhältnis zu der der Leiterplatte und der Steife beziehungsweise Dehnbarkeit des Leiterplattenmaterials ab. Allgemein wird man das Material der Einlage und seine Dicke so wählen, daß der thermische Ausdehungskoeffizient der Leiterplatte im Bereich mit Einlage sich dem der darauf zu montierenden Schaltungsbausteine gut anpaßt. Wie das Verhältnis der Dicken von Einlage und Leiterplattenmaterial zueinander für diesen Zweck sein muß, hängt selbstverständlich von der Art der Materialien ab und ist für eine gegebene Materialkombination leicht empirisch zu ermitteln. Allgemein wird man die Materialien von Leiterplatte und Einlage so wählen, daß eines davon einen größeren und das andere einen kleineren thermischen Ausdehnungskoeffizienten als die Schaltungsbausteine aufweist.

Um die thermische Belastung durch Temperaturwechsel und die Leiterplattenmasse gering zu halten, ist es wünschenswert, die Größe der Einlagen jeweils gering zu halten. Die Größe wird daher zweckmäßigerweise so festgelegt, daß nicht mehr als die notwendigen Schaltungsbausteine auf der Einlage Platz haben. Insbesondere können die Einlagen jeweils so bemessen sein, daß auf jeder nur ein einziger Schaltungsbaustein Platz findet.

Ein kleines Format der steifen Einlagen hat aber nicht nur den Vorteil, daß temperaturinduzierte Spannungen zwischen der Einlage und dem umgebenden Material der Leiterplatte auf das unumgängliche Maß reduziert bleiben, es führt auch zu einer Gewichtsersparnis bei der gesamten Schaltung.

Im Interesse der thermischen Stabilität der Leiterplatte ist es wünschenswert, daß die steife Einlage vollflächig am Material der Leiterplatte haftet. Ein Material, daß die erwünschten thermischen Ausdehnungseigenschaften hat und wirksam am Leiterplattenmaterial wie FR, insbesondere FR4 gut haftet, ist Molybdän. Es ist daher wünschenswert, daß die steifen Einlagen wenigstens an ihrer Oberfläche einen Anteil an Molybdän enthalten, insbesondere kann die gesamte Einlage als Plättchen aus Molybdän ausgebildet sein.

Weitere Merkmale und Vorteile der Erfindung ergeben sich aus der nachfolgenden Beschreibung von Ausführungsbeispielen mit Bezug auf die Figuren.

### Figuren

Es zeigen
- Figur 1: eine erfindungsgemäße Leiterplatte mit Bestückung im Querschnitt;
- Figur 2: eine Draufsicht auf die Leiterplatte aus Figur 1; und
- Figur 3: eine Draufsicht auf ein zweites Ausführungsbeispiel der Leiterplatte.

### Beschreibung der Ausführungsbeispiele

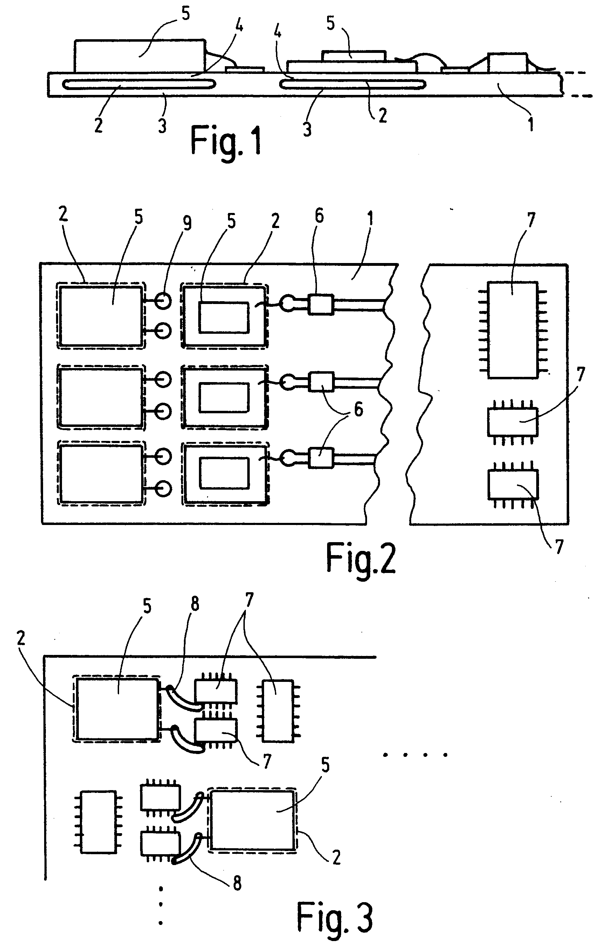

Figur 1 zeigt im Schnitt eine Leiterplatte aus an sich bekanntem FR4-Material, das normalerweise einen Ausdehnungskoeffizienten von 12 bis 16x10⁻⁶/°C aufweist. In die Leiterplatte 1 sind stellenweise plättchenförmige Molybdänteile 2 als steife Einlage eingebettet. Ihr thermischer Ausdehungskoeffizient ist deutlich geringer als der des FR4. Wenn die Leiterplatte sehr tiefen Temperaturen ausgesetzt ist, wie sie zum Beispiel bei einem Nachrichtensatelliten in der Umlaufbahn vorkommen können, halten die Einlagen 2 die Schichten 3 und 4 aus Leiterbahnmaterial, zwischen denen sie eingeschlossen sind, unter Zugbelastung und verringern so deren Schrumpfung. Durch passende Auswahl der Dicken der Einlagen 2 und der Schichten 3,4 läßt sich so der thermische Ausdehnungskoeffizient der Leiterplatte 1 am Ort der Einlagen 2 auf einen Wert von 3 bis 9, vorzugsweise 4 bis 6x10⁻⁶ /°C reduzieren. Dies entspricht dem Ausdehnungskoeffizienten von herkömmlichen Keramikgehäusen für Schaltungsbauteile, wie sie insbesondere für Schaltungsbauteile auf Galliumarsenidbasis beziehungsweise für MIC- oder MMIC-Bausteine verwendet werden. Derartige Schaltungsbausteine 5 können daher jeweils am Ort der Einlagen 2 auf der Leiterplatte 1 vollflächig befestigt werden, ohne daß sie und gegebenenfalls deren Lötstellen bei einer Abkühlung der Leiterplatte einer erheblichen mechanischen Spannungsbelastung ausgesetzt sind.

Bei einer Erwärmung der Leiterplatte 1, zum Beispiel weil die Schaltungsbausteine 5 eine hohe Verlustleistung abgeben, neigt das Material der Leiterplatte 1 dazu, sich stärker auszudehnen als die Einlagen 2. Um dies zu verhindern, ist es notwendig, daß die Schichten 3 und 4 jeweils vollflächig an der Einlage 2 haften, zum Beispiel durch eine geeignete Verklebung. Einer bevorzugten Ausgestaltung zufolge weisen die Einlagen 2 an ihrer Oberfläche jeweils erhebliche Anteile an Molybdän auf, im Interesse einer einfachen Fertigung können sie sogar ganz aus Molybdän bestehen. Dieses Material hat die günstige Eigenschaft, dass es eine fest haftende Verbindung mit dem FR4 der Leiterplatte einzugehen vermag.

Wie man erkennt, stehen die Einlagen 2 jeweils geringfügig über die Ränder der Schaltungsbausteine 5 vor. Dies ist besonders deutlich in Figur 2 zu sehen, wo die Schaltungsbausteine 5 in einer Draufsicht dargestellt sind und die Umrisse der in die Leiterplatte 1 eingebetteten Einlagen 2 jeweils durch gestrichelte Linien angedeutet sind. Die Umrisse der Einlagen 2 folgen jeweils im wesentlichen denen der Schaltungsbausteine 5, greifen aber am Rande geringfügig darüber hinaus. Kontaktpads 9 auf der Leiterplatte, an denen Anschlußdrähte der Schaltungsbausteine 5 gebondet sind, liegen außerhalb der Einlagen 2. Diese geringfügig größere Ausdehnung der Einlagen 2 ist sinnvoll, um einen im wesentlichen gleichförmigen thermischen Ausdehnungskoeffizienten an der gesamten Unterseite eines jeden Schaltungsbausteins 5 zu gewährleisten. Eine Übergangszone, in der der Ausdehnungskoeffizient der Leiterplatte 1 zwischen den Werten mit und ohne Einlage übergeht, liegt jeweils im Bereich der Ränder der Einlage 2 und wird von dem Schaltungsbaustein 5 nicht verdeckt.

Wie insbesondere Figur 2 deutlich zeigt, ist jedem einzelnen Schaltungsbaustein 5 eine eigene Einlage 2 zugeordnet. Im Prinzip wäre es auch möglich, alle Schaltungsbausteine 5 mit Keramikgehäuse über einer einzigen gemeinsamen Einlage anzuordnen. Die in Figur 2 dargestellte Lösung mit jeweils einer Einlage für jeden einzelnen Schaltungsbaustein 5 ist jedoch bevorzugt, da sie zum einen an Gewicht der Leiterplatte einspart und zum anderen die absoluten Längendifferenzen zwischen den Einlagen und dem sie umgebenden Leiterplattenmaterial, die sich durch die unterschiedlichen thermischen Ausdehnungskoeffizienten ergeben, kleiner sind. Eventuelle Ungleichverteilungen der temperaturinduzierten Scherkraft an der Grenzfläche zwischen der Einlage 2 und den sie umgebenden Schichten 3,4 können daher nicht so leicht zu einem Aufbrechen der Verbindung zwischen beiden führen.

Einlagen 2, die nur durch einen schmalen Zwischenraum wie etwa die horizontalen Zwischenräume in Figur 2 voneinander getrennt sind, können gemäß einer vereinfachten Variante auch miteinander zu einer größeren, mehrere Bausteine 5 tragenden Einlage verschmolzen sein.

Durchführungsfilter, die die von den Schaltungsbausteinen 5 mit Galliumarsenidsubstrat verarbeiteten Hochfrequenzsignale von den Versorgungsspannungen dieser Bausteine trennen, sind als SMD-Bauelemente 6 auf der Leiterplatte 1 angeordnet. Aufgrund der geringen Größe dieser Bauelemente können sie auf einem Bereich der Leiterplatte 1 ohne steife Einlage angeordnet sein, ohne daß dies zu Problemen durch thermische Spannungen führt.

Weitere Bauelemente 7 in Form von integrierten Schaltungen auf Siliciumgrundlage sind ebenfalls auf der Leiterplatte 1 in Bereichen ohne steife Einlage montiert.

Da derartig integrierte Schaltungen mit Siliciumsubstrat eine Größe von mehreren Zentimetern erreichen können, kann es auch bei diesen vorteilhaft sein, in der Leiterplatte 1 unter ihnen eine Einlage einzubetten, die den Ausdehnungskoeffizienten der Leiterplatte 1 lokal an den der Schaltung 7 anpaßt. Um im Bereich der Schaltung 7 einen anderen Ausdehnungskoeffizienten der Leiterplatte 1 zu realisieren als im Bereich der Schaltungsbausteine 5, kann für die Einlage ein Material mit anderem Ausdehnungskoeffizienten gewählt werden, oder das Verhältnis der Dicken von Einlage und umgebenden Schichten wird anders gewählt als im Bereich der Einlagen 2.

Figur 3 zeigt eine erfindungsgemäße Leiterplatte, auf der mehrere Gruppen von Schaltungsbausteinen 5 beziehungsweise 7 mit jeweils unterschiedlichem thermischen Ausdehnungskoeffizienten montiert sind. Unterhalb der Schaltungsbausteine 5 ist wiederum eine steife Einlage 2 in die Leiterplatte eingebettet. Die Schaltungsbausteine 5 und 7 sind jeweils durch Leiterbahnstücke wie etwa 8 elektrisch verbunden. Da die erfindungsgemäße Leiterplatte es erlaubt, die Schaltungsbausteine 5 und 7 mit jeweils unterschiedlichen thermischen Ausdehnungskoeffizienten in beliebiger örtlicher Beziehung zueinander anzuordnen, können die Leiterbahnstücke 8, die die zwei Gruppen von Schaltungsbausteinen miteinander verbinden, im Mittel kürzer gehalten werden als bei dem herkömmlichen Aufbau, der unterschiedliche Substrate für die zwei Gruppen erfordert. Leitungsverluste werden daher vermindert.

## Patentansprüche

1. Leiterplatte (1) für die Montage von wenigstens zwei Gruppen von Schaltungsbausteinen (5,6,7), die sich in ihren thermischen Ausdehnungskoeffizienten unterscheiden, **dadurch gekennzeichnet,** daß die Leiterplatte (1) an einem oder mehreren Orten mit einer steifen Einlage (2) ausgestattet ist, deren thermischer Ausdehnungskoeffizient sich von dem des Materials der Leiterplatte (1) unterscheidet, so daß der Ausdehnungskoeffizient der Leiterplatte an diesem Ort/diesen Orten vom Ausdehnungskoeffizienten der Leiterplatte an Orten, die die Einlage nicht aufweisen, unterscheidet.

2. Leiterplatte nach Anspruch 1, **dadurch gekennzeichnet,** daß der Ausdehnungskoeffizient der Leiterplatte am Ort einer steifen Einlage (2) im Bereich von 3 bis 9, vorzugsweise von 4 bis 6x10⁻⁶/°C liegt.

3. Leiterplatte nach Anspruch 1 oder 2, **dadurch gekennzeichnet,** daß sie an den Orten mit steifer Einlage (2) jeweils mit Schaltungsbausteinen (5) nur einer der zwei Gruppen bestückt ist.

4. Leiterplatte nach Anspruch 3, **dadurch gekennzeichnet,** daß an jedem Ort mit steifer Einlage (2) ein Schaltungsbaustein (5) montiert ist.

5. Leiterplatte nach Anspruch 3 oder 4, **dadurch gekennzeichnet,** daß die Form jeder steifen Einlage (3) im wesentlichen der Form des/der darauf montierten Schaltungsbausteins/-steine (5) entspricht.

6. Leiterplatte nach einem der vorhergehenden Ansprüche, **dadurch gekennzeichnet,** daß eine Gruppe von Schaltungsbausteinen (5) Keramikgehäuse aufweist.

7. Leiterplatte nach einem der vorhergehenden Ansprüche, **dadurch gekennzeichnet,** daß eine Gruppe von Schaltungsbausteinen Schaltungsbausteine (7) auf Siliciumbasis und eine andere Gruppe Schaltungsbausteine (5) auf Galliumarsenidbasis aufweist.

8. Leiterplatte nach einem der Ansprüche 1 bis 6, **dadurch gekennzeichnet,** dass eine Gruppe von Schaltungsbausteinen MIC- oder MMIC-Bausteine umfaßt.

9. Leiterplatte nach einem der vorhergehenden Ansprüche, **dadurch gekennzeichnet,** daß die steife Einlage (2) vollflächig am Material der Leiterplatte (1) haftet.

10. Leiterplatte nach einem der vorhergehenden Ansprüche, **dadurch gekennzeichnet,** daß die steife Einlage (2) wenigstens an ihrer Oberfläche Molybdän enthält.

11. Leiterplatte nach Anspruch 10, **dadurch gekennzeichnet,** daß die steife Einlage ein Plättchen aus Molybdän ist.

12. Leiterplatte nach einem der Ansprüche 1 bis 10, **dadurch gekennzeichnet,** dass die Einlage ein Plättchen aus Kohlefaserwerkstoff aufweist.

13. Leiterplatte nach einem der vorhergehenden Ansprüche, **dadurch gekennzeichnet**, dass das Material der Leiterplatte sowie das Verhältnis der Dicken der steifen Einlage (2) und des Materials der Leiterplatte in einem mit steifer Einlage (2) versehenen Bereich so gewählt sind, daß der thermische Ausdehnungskoeffizient dieses Bereichs dem der Schaltungsbausteine (5) einer Gruppe entspricht.
